Europäisches Patentamt

European Patent Office

Office européen des brevets

(19)

(11) Publication number: 0 383 490
A2

# (12) EUROPEAN PATENT APPLICATION

(21) Application number: 90301359.7

(22) Date of filing: 08.02.90

(51) Int. Cl.5: G11C 19/00, G11C 7/00

(30) Priority: 14.02.89 JP 33975/89

(43) Date of publication of application:
22.08.90 Bulletin 90/34

(84) Designated Contracting States:
DE FR GB NL

(71) Applicant: MATSUSHITA ELECTRIC
INDUSTRIAL CO., LTD.
1006, Oaza Kadoma
Kadoma-shi Osaka 571(JP)

(72) Inventor: Misaki, Hirozumi
P-103 Aobaoka 8-ban
Suita-shi, Osaka(JP)

(74) Representative: Crawford, Andrew Birkby et al
A.A. THORNTON & CO. Northumberland
House 303-306 High Holborn
London WC1V 7LE(GB)

(54) Shift register circuit.

(57) The invention presents a shift register circuit, in which $n+1$ shift registers are connected in cascade and the output data of the $n+1$-th stage flip-flop is maintained in a specific state while n clock signals are being fed, and the output data of the $n+1$-th stage flip-flop is inverted in synchronism with the $n+1$-th clock signal.

Thus, by utilizing the output data of the $n+1$-th stage flip-flop, only n clock signals are fed into all flip-flops, so that the data fed into the first stage flip-flop may be correctly transferred to n flip-flops from the first stage till the n-th stage. As a result, the counter circuits in complicated circuit composition as used in the conventional shift register circuit are not required, and the circuit structure of the shift register circuit is simplified, and the chip area of the semiconductor device in which the shift register circuit is incorporated may be reduced in size.

FIG. 1

## SHIFT REGISTER CIRCUIT

### BACKGROUND OF THE INVENTION

The present invention relates to a shift register circuit composed of multiple stages of flip-flops.

Semiconductor memory devices are widely used in electronic appliances such as electronic tuners of television receivers.

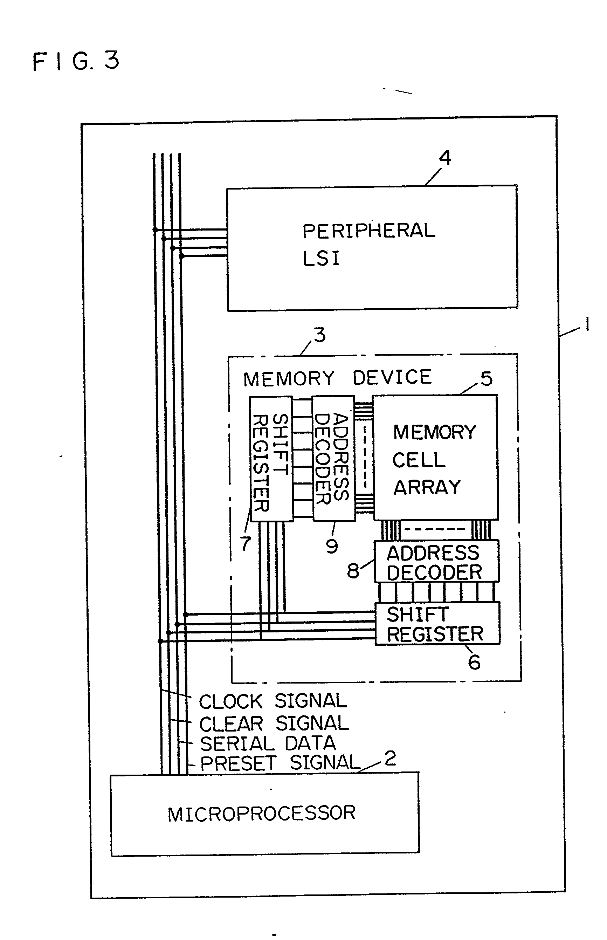

Fig. 3 shows conceptually a part of such electronic appliance.

In Fig. 3, in an electronic appliance 1 such as electronic tuner, there are, among others, microprocessor 2, memory device 3 such as EEPROM, and other peripheral LSI 4. The memory device 3 contains a memory cell array 5 having multiple memory cells (not shown) in a matrix array, shift registers 6, 7, and address decoders 8, 9. The shift register 6 converts the serial data delivered from the microprocessor 2 into, for example, parallel data of 8 bits, depending on the preset signal, clear signal or clock signal delivrered from the microprocessor 2. The address decoder 8 selects and activates one of the multiple word lines depending on the 8-bit parallel data delivered from the shift register 6. On the other hand, the shift register 7, same as the shift register 6, converts the serial data from the microprocessor 2 into parallel data of, for example, 8 bits. The address decoder 9 selects and activates one of the multiple bit lines according to the 8-bit parallel data delivered from the shift register 7. The memory cell positioned at the intersection of thus activated word line and bit line is selected, and the data written in that memory cell is read out. The read data is used in selection on channel or the like of the television receiver, for example, together with the output signal from the peripheral LSI 4.

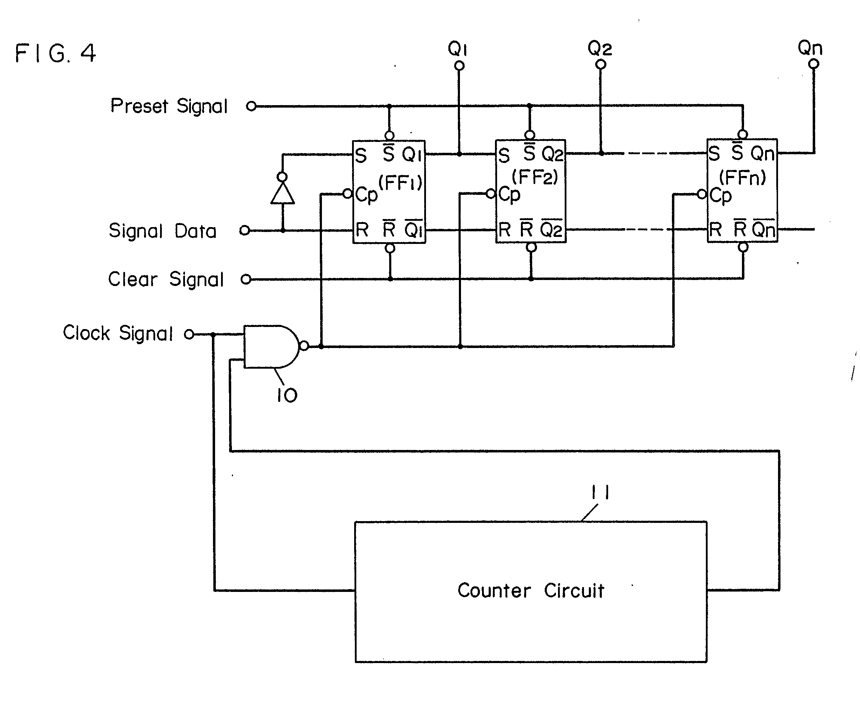

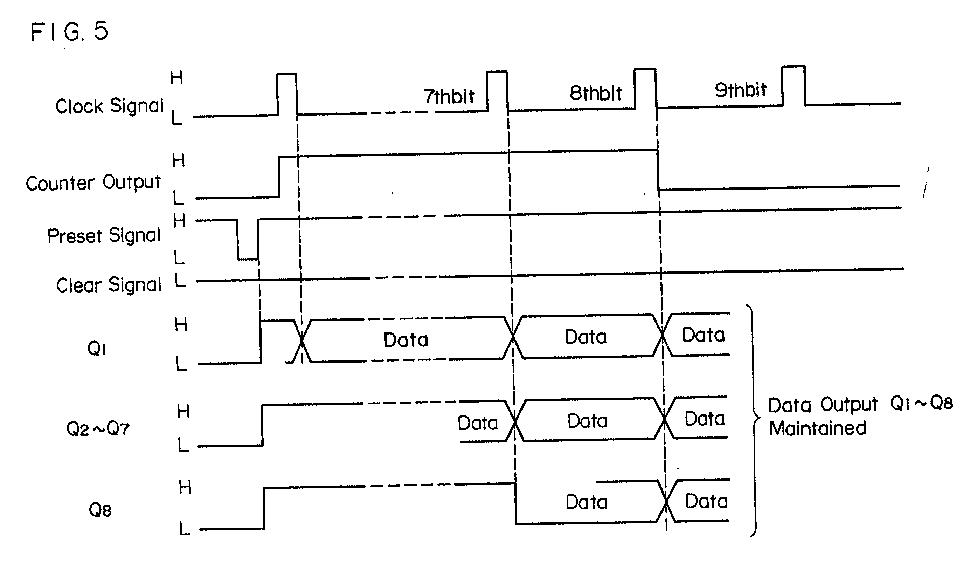

Fig. 4 shows a conventional shift register circuit used as shift register 6 or 7 in Fig. 3. Fig. 5 shows a timing chart of shift register circuit of Fig. 4.

In Fig. 4, FF1 to FFn denote flip-flops. Each flip-flop comprises data input terminals (set terminal S, reset terminal R), data output terminals Q, $\overline{Q}$, preset terminal $\overline{S}$, clear terminal $\overline{R}$, and clock terminal Cp. The serial data and the inverted data are fed into the set terminal S and reset terminal R of the flip-flop FF1 of the first stage. In the second and subsequent flip-flops FF2 to FFn, the Q output of the preceding flip-flops FF1 to FFn-1 is fed into the set terminal S, and the $\overline{Q}$ output in the reset terminal R, respectively. The preset signal is fed into the preset terminals $\overline{S}$ of all flip-flops FF1 to FFn. The clear signal is fed into the clear terminal $\overline{R}$ of all flip-flops FF1 to FFn. The clock signal is fed into one of the input terminals of NAND gate 10 and counter circuit 11. The output signal of the counter circuit 11 is fed into the other input terminal of the NAND gate 10. The output signal of the NAND gate 10 is fed into the clock terminal Cp of all flip-flops FF1 to FFn. Output terminals Q1 to Qn are connected to the Q output terminals of all flip-flops FF1 to FFn.

The operation of the shift register circuit shown in Fig. 4 is explained below while referring to Fig. 5. For the sake of simplicity of description, an example of converting serial data into 8-bit parallel data (that is, n = 8) is described below.

As shown in Fig. 5, when the Q outputs of all flip-flops FF1 to FF8 are turned to H by the preset signal, a first clock signal is fed, and synchronizing with its rise, the output of the counter circuit 11 changes to H. As a result, the NAND gate 10 is opened, and the first clock signal and a series of clock signals to follow in succession are all fed into the clock terminal Cp of all flip-flops FF1 to FF8. In consequence, in the first flip-flop FF1, the data is latched in synchronism with the fall of the first clock signal. Similarly, the second to seventh flip-flops FF2 to FF7, in synchronism with the fall of each clock signal from the second bit to the seventh bit, sequentially latch the data once latched in the preceding flip-flop. The final flip-flop FF8, in synchronism with the fall of the clock signal of the eighth bit, latches the data of the preceding flip-flop FF7. During the transfer period of this series of serial data, the clock signal is also fed continuously into the counter circuit 11, and the counter circuit 11 counts up the number of clock signals. As shown in the example in Fig. 5, in a shift register circuit employing eight flip-flops FF1 to FF8, it is enough to connect a three-bit counter circuit 11. Thus, synchronizing with the fall of the clock signal of the eighth bit, the output signal of the counter circuit 11 changes to L, and the NAND gate 10 is closed. Accordingly, if a clock signal of the ninth bit is entered, the state of flip-flops FF1 to FF8 is not changed, and the 8-bit data latched by the clock signal of the eighth bit is protected.

The 8-bit parallel data Q1 to Q8 thus converted from serial to parallel are fed into the address decoder 8, and one word line corresponding to the parallel data Q1 to Q8 is selected.

In the other shift register 7 shown in Fig. 3, by the same operation as the shift register 6, the serial data is converted into 8-bit parallel data, and one data line corresponding to the 8-bit parallel data is selected.

As a result, from the memory cell located at the intersection of the selected word line and data line, the data stored in the memory cell is read out.

Incidentally, as clear from Fig. 3, the clock signal and others delivered from the microprocessor 2 are supplied not only to the shift registers 6, 7 of the memory device 3, but also to the other shift registers incorporated in the peripheral LSI 4, and are also utilized in a completely different operation under the timing control of the microprocessor 2. In other words, regarding the shift register 6 in the memory device 3, the clock signal is continuously fed even after the clock signals for 8 bits necessary for serial-parallel conversion are all supplied, and therefore after the data inputs into all flip-flops FF1 to FF8 are finished by the clock signals for 8 bits, the parallel data Q1 to Q8 are changed by the clock signal of the ninth bit.

To solve such problem, in the conventional shift register circuit shown in Fig. 4, NAND gate 10 and counter circuit 11 are provided, and when the necessary clock signals are fed, the NAND gate 10 is closed by the output of the counter circuit 11, and the subsequent clock signals are blocked.

In such conventional constitution, however, one counter circuit 11 is needed for each one of the shift register circuits. For example, in the case of a shift register with eight flip-flops (8-bit shift register), counter circuits of three bits are needed, and in a shift register with 16 flip-flops (16-bit shift register), counter circuits of four bits are required.

Usually, many shift register circuits are needed even within the memory device 3 shown in Fig. 3 only, and multiple shift register circuits are incorporated in the peripheral LSI 4. Therefore, in the conventional structure requiring counter circuits in all shift register circuits, the circuit scale becomes too large, and the size of the semiconductor device fabricated such shift register circuits becomes very big.

It is hence a primary object of the invention to present a shift register circuit capable of holding correctly the n-bit parallel data Q1 to Qn, even if the clock signals are fed continuously after input of n pieces of serial data into n stages of shift registers, without using counter circuits.

## SUMMARY OF THE INVENTION

To achieve the above object, in the shift register circuit of the invention, $n+1$ shift registers are connected in cascade and the output data of the $n+1$-th stage flip-flop is maintained in a specific state while n clock signals are being fed, and the output data of the $n+1$-th stage flip-flop is inverted in synchronism with the $n+1$-th clock signal.

Thus, by utilizing the output data of the $n+1$-th stage flip-flop, only n clock signals are fed into all flip-flops, so that the data fed into the first stage flip-flop may be correctly transferred to n flip-flop from the first stage till the n-th stage. As a result, the counter circuits in complicated circuit composition as used in the conventional shift register circuit are not required, and the circuit structure of the shift register circuit is simplified, and the chip area of the semiconductor device in which the shift register circuit is incorporated may be reduced in size.

## BRIEF DESCRIPTION OF THE DRAWINGS

Fig. 1 is a block diagram showing a shift register circuit in one of the embodiments of the invention;

Fig. 2 is a timing chart of the shift registers circuit of Fig. 1;

Fig. 3 is a conceptual drawing showing the essential part of a general electronic appliance;

Fig. 4 is a block diagram showing a conventional shift register circuit; and

Fig. 5 is a timing chart of the shift register circuit of Fig. 4.

## DETAILED DESCRIPTION OF THE INVENTION

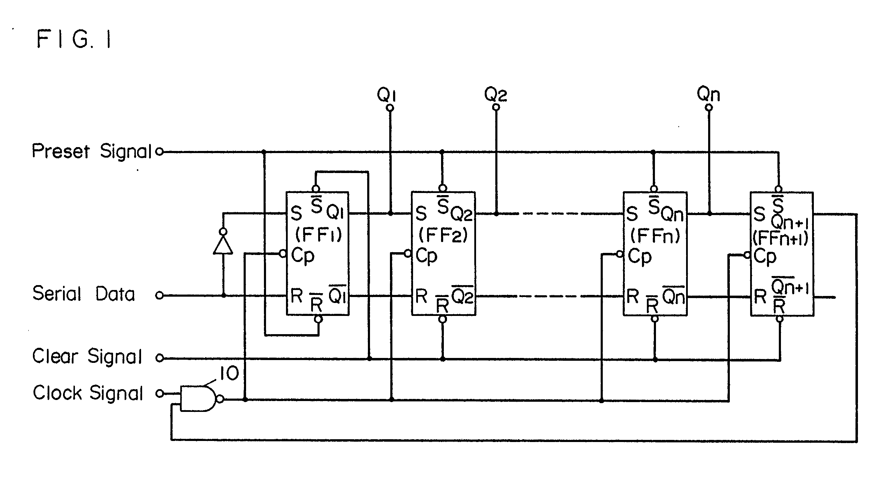

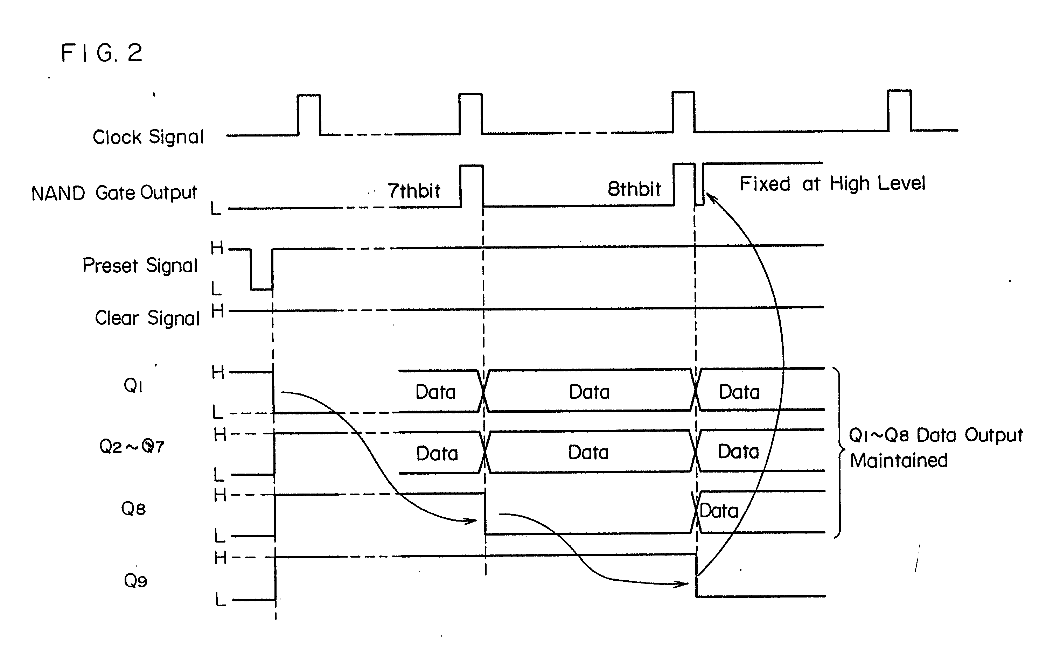

Referring now to the drawings, Fig. 1 and Fig. 2, one of the embodiments of the invention is described in detail below.

Fig. 1 is a block diagram of a shift register circuit in an embodiment of the invention, and Fig. 2 is its timing chart.

In Fig. 1, each one of $n+1$ flip-flops FF1 to FFn+1 comprises data input terminals (set terminal S, reset terminal R), data output terminals Q, $\overline{Q}$, preset terminal $\overline{S}$, clear terminal $\overline{R}$, and clock terminal Cp. The serial data and its inverted data are fed respectively to the set terminal S and reset terminal R of the first flip-flop FF1. In the second and subsequent flip-flops FF2 to FFn+1, the Q output of the preceding flip-flops FF1 to FFn is fed into the set terminal S, and the $\overline{Q}$ output into the reset terminal R. The preset signal is fed to the clear terminal $\overline{R}$ in the first flip-flop FF1, and to the preset terminal $\overline{S}$ in the second and subsequent flip-flops FF2 to FFn+1. On the other hand, the clear signal is fed to the preset terminal $\overline{S}$ in the first flip-flop FF1, and to the clear terminal $\overline{R}$ in the second and subsequent flip-flops FF2 to FFn+1. The clock signal is fed to the other input terminal of the NAND gate 10. The output signal of the NAND gate 10 is fed to the clock terminal Cp of all flip-flops FF1 to FFn+1. And the Q output of the final flip-flop FFn+1, that is, the output data from the Qn+1 terminal is fed to the other input terminal of the NAND gate 10. Output terminals Q1 to Qn are connected individually to the Q output terminals of n stages of flip-flops FF1 to FFn.

The features of the shift register circuit shown in Fig. 1 include the following.

(1) In converting serial data into n-bit parallel data, flip-flops FF1 to FFn + 1 composed of n + 1 stages are provided.

(2) In the first flip-flop FF1, the input terminals of preset signal and clear signal are exchanged, and the preset signal is fed to the clear terminal $\overline{R}$ and the clear signal to the preset terminal $\overline{S}$. In the second and subsequent flip-flops FF2 to FFn + 1, the preset signal is fed to the preset terminal $\overline{S}$ and the clear signal to the clear terminal $\overline{R}$, respectively.

(3) The Q output of the n + 1-th flip-flop FFn + 1 (the output data of Qn + 1 terminal) is fed to one of the input terminals of the NAND gate 10, and all output signals of the NAND gate 10 are fed to the clock terminal Cp of all flip-flops FF1 to FFn + 1.

The operation of the shift register circuit in Fig. 1 is explained together with the timing chart in Fig. 2. For the sake of simplicity of explanation, an example of converting serial data into parallel data of 8 bits is explained also herein. That is, in Fig. 1, n is 8, and the shift register circuit is composed of 9 stages of flip-flops in the following description of the operation.

First, when a preset signal is fed, in synchronism with the terminal end of the preset signal pulse, that is, the rise of the preset signal, the Q outputs Q2 to Q9 of the second to the ninth flip-flops FF2 to FF9 are simultaneously changed to H. In the first flip-flop FF1, however, since the preset signal is fed to the clear terminal $\overline{R}$, different from the other flip-flops, the Q output is changed to L in synchronism with the preset signal. The Q output of the ninth flip-flop FF9 is fed to one of the input terminals of the NAND gate 10. Accordingly, when the Q output of the ninth flip-flop FF9 is changed to H, the NAND gate 10 opens. In this state, when a clock signal is fed, serial data is latched in the first flip-flop FF1 in synchronism with the fall of the first clock signal. Similarly, the second to ninth flip-flops FF2 to FF9 sequentially latch the data once latched in the preceding flip-flop, in synchronism with the fall of each one of second and subsequent clock signals. That is, by feeding a series of clock signals as shift clocks to the clock terminals Cp of the flip-flops FF1 to FFn + 1, the serial data is latched in eight flip-flops, and 8-bit parallel data can be delivered from the output terminals Q1 to Q8.

Thus, each flip-flop sequentially transfers the data of the preceding flip-flop in synchronism with the clock signal. Therefore, the Q output of the first flip-flop FF1 changed to L by the preset signal is transferred toward the second to the ninth flip-flops sequentially, in synchronism with the clock signal.

Fig. 2 shows the state of the seventh bit and eighth bit of clock signal. At the seventh bit of the clock signal, the Q output "L" set in the first flip-flop FF1 at the first bit of the clock signal is transferred up to the eighth flip-flop FF8 by the shift operation of the clock signal. In this state, therefore, correct data converted from serial data to parallel data is delivered to the output terminals Q1 to Qn. On the other hand, the Q output of the ninth flip-flop FF9 remains at H as being set by the preset signal, and the NAND gate 10 is kept open so that a series of clock signals may be fed into each flip-flop.

In this state, when a clock signal of the eighth bit is fed, the data of each flip-flop is further shifted by one step each in synchronism with the fall, and 8-bit parallel data is delivered to the output terminals Q1 to Q8. Simultaneously, the "L" data appearing so far in the Q output of the eighth flip-flop FF8 is transferred to the ninth flip-flop FF9. As a result, the output of the NAND gate 10 is fixed at high level right after the Q output of the ninth flip-flop FF9 is changed to L level as shown in Fig. 2, thereby blooking input of clock signals after the ninth bit. Therefore, in the electronic appliance as shown in Fig. 3, if clock signals after the ninth bit are fed continuously, the data Q1 to Q8 of the eight flip-flops FF1 to FF8 may maintained correctly.

Thus, according to the embodiment in Fig. 1, without using counter circuits, eight clock signals are detected, and input of the clock signals after entry of eight pieces of serial data into the shift register may be stopped. The circuit added for this purpose is only one flip-flop installed in the final stage (in the embodiment in Fig. 1, the ninth one), and the entire circuit structure may be notably reduced as compared with the conventional structure of adding counter circuits.

Incidentally, an example of converting serial data into 8-bit parallel data is shown in Fig. 2, but the invention may be also applied in the cases of converting into parallel data of 4 bits, 16 bits, or other bits than 8 bits. In the conventional structure using counter circuits, the number of bits of the counter circuits must be increased as the number of bits of parallel data is greater, but according to the invention it is enough to add only one flip-flop regardless of the number of bits. Thus, in the invention, as the number of bits is greater and as the number of shift register circuits incorporated in the system or device is greater, the total circuit scale may be greatly reduced as compared with the conventional shift register circuit using a counter circuit.

Meanwhile, in the embodiment in Fig. 1, the NAND gate 10 is used as the logic circuit or the gating circuit, but it may be replaced by other logic circuit as far as an equivalent function is exhibited.

## Claims

1. A shift register circuit comprising:
n + 1 (n: an integer of 2 or greater) flip-flops connected in cascade;
means for holding the output data of the n + 1-th flip-flop in a first state for the period determined by n clock signals, and inverting the output data of said n + 1-th flip-flop into a second state, in synchronism with the n + 1-th clock signal; and
means for feeding n clock signals to n flip-flops from the first stage till the n-th stage, on the basis of the output data of said n + 1-th flip-flop, and transferring the data fed into the first flip-flop into the succeeding flip-flops successively.

2. A shift register circuit comprising:
n + 1 (n: an integer of 2 or greater) flip-flops connected in cascade;
means for setting only the first flip-flop out of said n + 1 flip-flops in a first state, and setting all other flip-flops in a second state; and
means for feeding n continuous clock signals to the clock terminals of all of said flip-flops, on the basis of the output data of the n + 1-th flip-flop, and transferring the data fed in the data input terminal of the first flip-flop into the succeeding flip-flops sequentially.

3. A shift register circuit comprising:
n + 1 (n: an integer of 2 or greater) flip-flops connected in cascade;
means for setting only the first flip-flop out of said n + 1 flip-flops in a first state, and setting all other flip-flops in a second state;
gate means for passing only continuous n clock signals, on the basis of the output data of the n + 1-th flip-flop;
means for transferring the serial data fed into the data input terminal of the first flip-flop to the succeeding flip-flops sequentially, in synchronism with the n clock signals, and storing the data in n flip-flops from the first stage till the n-th stage; and
means for delivering n-bit parallel data stored in said n flip-flops.

4. A shift register circuit comprising:
n + 1 (n: an integer of 2 or greater) flip-flops, wherein each flip-flop comprises a pair of data input terminals, a pair of data output terminals, a preset terminal, a clear terminal and a clock terminal;
means for feeding preset signals to the clear terminal of said first flip-flop and to the preset terminals of all other flip-flops of the second and subsequent stages;
means for feeding clear signals to the preset terminal of said first flip-flop and to the clear terminals of all other flip-flops of the second and subsequent stages;
gate means for passing only continuous n clock signals, on the basis of the output data of the n + 1-th flip-flop;
means for transferring the serial data fed to the data input terminal of said first flip-flop to the succeeding flip-flops sequentially, in synchronism with the n clock signals, and storing the data in n flip-flops from the first stage till the n-th stage; and
means for delivering n-bit parallel data stored in said n flip-flops.

F I G. I

# F I G. 2

EP 0 383 490 A2

F I G. 3

PERIPHERAL LSI — 4

I

MEMORY DEVICE — 3

SHIFT REGISTER

ADDRESS DECODER

MEMORY CELL ARRAY — 5

7

9

ADDRESS DECODER — 8

SHIFT REGISTER — 6

CLOCK SIGNAL
CLEAR SIGNAL
SERIAL DATA
PRESET SIGNAL — 2

MICROPROCESSOR

FIG. 4

Preset Signal

Signal Data

Clear Signal

Clock Signal

Q1   Q2   Qn

S S̄ Q1 (FF1)
Cp
R R̄ Q1̄

S S̄ Q2 (FF2)
Cp
R R̄ Q2̄

S S̄ Qn (FFn)
Cp
R R̄ Qn̄

10

11

Counter Circuit

EP 0 383 490 A2

# FIG. 5

Clock Signal

Counter Output

Preset Signal

Clear Signal

Q1

Q2~Q7

Q8

7thbit    8thbit    9thbit

Data    Data    Data

Data    Data    Data

Data    Data

Data Output Q1~Q8
Maintained

EP 0 383 490 A2